# DEMANDE DE BREVET EUROPEEN

(11) **EP 0 522 986 A1**
(43) Date de publication de la demande: **13.01.1993**
(21) Numéro de dépôt: 92420233.6
(22) Date de dépôt: 09.07.1992
(51) Int. Cl.: C23C 16/26, C23C 16/50, H01J 37/32

(54) **Dispositif et procédé de dépot de diamant par DCPV assisté par plasma microonde**

(30) Priorité: 12.07.1991 FR 9109552
(71) Demandeur: PECHINEY RECHERCHE (Groupement d'Intérêt Economique régi par l'Ordonnance du 23 Septembre 1967), F-92400 Courbevoie la Défense 5 (FR)
(72) Inventeur: Bou, Pierre, F-45100 Orleans la Source (FR); Vandenbulcke, Lionel, F-45650 Saint Jean le Blanc (FR); Quilgars, Alain, F-45370 Jouy le Potier (FR); Coulon, Michel, F-95160 Montmorency (FR); Moisan, Michel, Outremont H2V 2Z1, Quebec (CA)
(74) Mandataire: Jacquet, Michel

(57) **Abrégé**

Dispositif de dépôt de diamant sur substrat, assisté par plasma microonde, qui comporte a) une chambre de dépôt (1), dont une portion est placée dans un guide d'ondes (2), comprenant deux zones, l'une, étant la zone (10) de formation du plasma située à l'intérieur du guide d'ondes (2), et l'autre, étant la zone (11) de dépôt du diamant située hors du guide d'ondes (2), b) des moyens permettant de former un plasma stable dans la zone de dépôt (11), de manière à augmenter considérablement la surface de substrat à traiter.

Procédé de dépôt de diamant utilisant le dispositif selon l'invention.

Application au dépôt sur pièces monobloc de grande taille.

## Description

### DOMAINE DE L'INVENTION

L'invention concerne un dispositif et un procédé pour déposer du diamant sur un substrat par DCPV (dépôt chimique en phase vapeur) assisté par plasma microonde.

### RAPPEL DE L'ART ANTERIEUR

On connaît déjà de nombreux documents relatant la synthèse du diamant à basse pression, à partir d'un gaz hydrocarboné. Dans tous les cas, le principe du procédé de la synthèse basse pression consiste à dissocier le gaz porteur de carbone, en présence d'un graveur sélectif du graphite (un graveur est un agent qui réagit avec un solide -ici le graphite - et qui le renvoie dans la phase vapeur) tel qu'une forte pression en hydrogène atomique, ce qui peut être obtenu à l'aide de moyens divers tels qu'une torche oxy-acétylénique, ou encore un plasma froid mettant en jeu des radio-fréquences ou des microondes.

On rencontre aussi des dispositifs et procédés qui associent plusieurs procédés de base. Ainsi, le brevet européen N° 0 272 418 A2 décrit un procédé de synthèse basse pression dans lequel le plasma est formé dans une chambre, placée dans une cavité microonde, dans laquelle un filament est porté à haute température. Dans cette chambre, se trouve le substrat sur lequel est déposé le diamant.

### PROBLEME POSE

Les dispositifs et procédés basse pression à plasma froid et en particulier ceux faisant appel à la formation de plasma froid par microonde sont particulièrement intéressants compte tenu des conditions expérimentales relativement "douces" qu'ils mettent en oeuvre. Cependant, tous ces procédés ont une limitation importante en pratique qui est le volume de la chambre de dépôt, ou encore la surface utile de dépôt. Ces limitations d'ordre géométrique (dimensions des cavités résonantes ou des guides d'onde) résultent en partie de la nature ondulatoire des microondes, des longueurs d'onde associées (12,24 cm pour une fréquence de 2,45 GHz) et de la physique des plasmas.

### OBJET DE L'INVENTION

L'invention a pour premier objet un dispositif pour déposer du diamant sur un substrat à revêtir par DCPV assisté par plasma microonde, permettant d'augmenter considérablement la surface de substrat à traiter, et typiquement de la multiplier par 6. Un autre objet de l'invention est un procédé utilisant le dispositif selon l'invention.

### DESCRIPTION DE L'INVENTION

Selon l'invention, le dispositif de dépôt de diamant sur substrat, assisté par plasma microonde comporte une chambre de dépôt (1), dont une portion est placée dans un guide d'onde (2) alimenté par un générateur de microondes (4) et équipé d'un dispositif annihilant la puissance réfléchie vers ce générateur, chambre qui contient un substrat (5) à traiter placé sur un support (6), des moyens de chauffage du substrat, des moyens pour faire circuler dans ladite chambre, et sous une pression faible et régulée, un gaz plasmagène (7) et un mélange gazeux réactif (8) constitué d'hydrogène et de gaz porteur de carbone, et est caractérisé en ce que, de manière à obtenir un plasma stable (9) dans un grand volume et/ou sur une grande surface,
a) la chambre de dépôt (1) comprend deux zones raccordées, l'une, de petit volume, étant la zone (10) dite de formation du plasma située à l'intérieur du volume délimité par le guide d'ondes (2), et l'autre, de grand volume/ de grande surface, étant la zone (11) dite de dépôt du diamant située hors du volume délimité par le guide d'ondes (2), et contenant ledit substrat (5) à traiter,
b) ledit guide d'ondes (2) est muni de moyens permettant de former un plasma stable dans la zone de dépôt (11), située hors du volume délimité par le guide d'ondes (2) et contenant le substrat (5) à traiter.

La demanderesse a recherché des moyens pour augmenter la zone de propagation du plasma. Elle a trouvé que les dispositifs nommés "surfaguide", "surfatron", et "surfatron à guide d'onde" (SGO en abrégé), en anglais "waveguide surfatron", présentaient un intérêt pour réaliser la présente invention. En particulier, le dispositif préféré selon l'invention est le SGO.

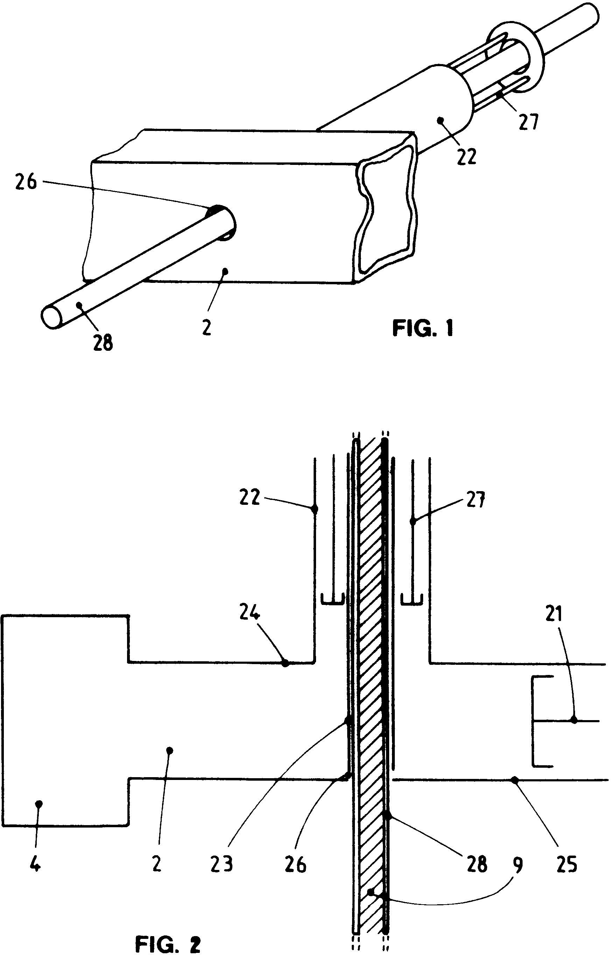

Le SGO est décrit dans une publication de M. MOISAN et col. parue dans J. Phys. E:Sci.Instrum. **20** (1987) 1356-1361. Les figures 1 et 2 extraites de cette publication montrent les éléments caractéristiques d'un SGO :
- un guide d'ondes (2), typiquement un tube à section rectangulaire, alimenté en énergie microonde venant d'un générateur de microondes (magnétron), et qui se termine par un piston (21) guide d'onde permettant d'ajuster le chemin électromagnétique de l'onde,
- une ligne coaxiale perpendiculaire au guide d'ondes (2) comprenant deux tubes métalliques coaxiaux : un tube extérieur (22) raccordé à une paroi (24) du guide d'onde, un tube intérieur (23) coaxial plongeant dans le guide d'onde (2) jusqu'à une paroi (25) parallèle à la première, de manière à laisser un interstice circulaire (26) permettant le passage des ondes électromagnétiques.

Entre les deux tubes coaxiaux (22) et (23), un piston coaxial (27) permet d'ajuster le chemin électromagnétique de l'onde.

Quand un tube (28), constitué d'un diélectrique, et typiquement en quartz, est placé à l'intérieur du tube intérieur (23) et traverse de part en part le guide d'onde et la ligne coaxiale qui lui est perpendiculaire, le SGO, en fonctionnement, crée, dans l'interstice circulaire (26) un champ électrique excitateur parallèle à l'axe du tube (28) qui permet simultanément l'ionisation des gaz contenus dans le tube et donc la formation d'un plasma (9), et la propagation des ondes de surface, de sorte que la colonne de plasma (9) s'étend jusqu'à l'endroit où l'énergie transportée par l'onde n'est plus suffisante pour créer une densité électronique supérieure à la densité de coupure de la décharge. Ainsi, une colonne de plasma (9) peut être maintenue stable dans un tube en verre ou en quartz, en dehors du guide d'onde et de la ligne coaxiale, entouré seulement par l'air ambiant.

La demanderesse a étudié les possibilités offertes par le SGO pour atteindre les objectifs de l'invention et a mis au point un dispositif pour former, par DCPV, du diamant sur une grande surface de substrat.

Selon l'invention, le SGO comporte un générateur de microondes de grande puissance, typiquement au moins égale à 5 kW, fonctionnant à la fréquence de 2,45 GHz qui correspond à une fréquence des générateurs standards actuels. Cependant, l'invention peut être mise en oeuvre à d'autres fréquences, typiquement à des fréquences comprises entre 0,05 et 10 GHz.

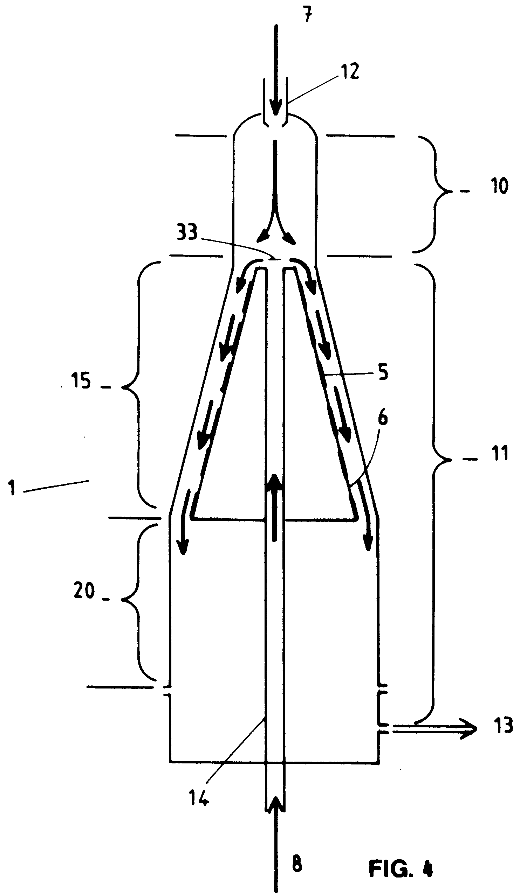

Le dispositif selon l'invention associe le SGO à une chambre de dépôt (1), le plus souvent à symétrie cylindrique, dont la zone (11) dite de dépôt du diamant comprend avantageusement une partie à paroi (15) tronconique, de diamètre maximum pouvant dépasser le double de celui de la zone (10) dite de formation du plasma.
Cette partie à paroi tronconique est la partie active pour le dépôt de diamant : le plasma volumique y occupe tout l'espace compris entre le support (6) en forme de cone tronqué et la paroi (15) tronconique de la zone de dépôt (11). Cet espace réactif a donc dans ce cas sensiblement la forme d'une couronne tronconique.
Cette partie à paroi tronconique est prolongée par une partie à paroi cylindrique (20) terminée par un fond (29) sur lequel sont branchés les équipements nécessaires au fonctionnement dudit dispositif, notamment les moyens de pompage (13), de mesure (16) et de régulation (17) de la pression dans la chambre de dépôt (1).
Selon une modalité de l'invention, l'angle au sommet du support (6) en forme de cone tronqué peut être moins aigu que l'angle au sommet de la paroi tronconique (15), comme schématisé à la figure 4, de manière à réduire l'espace réactif (distance entre la paroi tronconique (15) et le support (6)) et ainsi à compenser les phénomènes d'appauvrissement en réactif et d'hétérogénéité du plasma dans la direction longitudinale de l'espace réactif.

Dans le dispositif selon l'invention, il est avantageux que le flux de gaz plasmagène (7) traverse l'ensemble de la chambre de dépôt grâce à un injecteur (12) situé à une extrémité de la chambre de dépôt (1) et grâce à des moyens de pompage (13) située à l'autre extrémité. De manière plus précise, l'injecteur est positionné à une extrémité de la zone (10) dite de formation du plasma, alors que les moyens de pompage sont positionnés à l'extrémité de la zone (11) dite de dépôt du diamant.
Il est également avantageux selon l'invention, d'introduire le mélange gazeux réactif (8), dans la chambre de dépôt (1), à la limite des zones (10) et (11) à l'aide d'une alimentation centrale (14) traversant la zone (11) et munie éventuellement d'un déflecteur (33) produisant un flux radial, de manière que le flux de mélange gazeux réactif (8) et de gaz plasmagène (7) se mélangent en formant un seul flux gazeux homogène se déplaçant parallèlement à la paroi (15) de la zone (11) dite de dépôt de diamant grâce aux dits moyens de pompage (13).
Tous ces éléments caractéristiques de l'invention sont représentés schématiquement sur la figure 4.

Dans une variante du dispositif selon l'invention, le mélange gazeux réactif (8) est distribué sur toute la hauteur de la zone (11) de dépôt de diamant de manière à avoir un mélange gazeux réactif (8) sensiblement homogène dans tout l'espace réactif (espace compris entre la paroi (15) et le support (6)). Pour cela, l'alimentation centrale (14) est munie de plusieurs orifices (35) débouchant en différents points de l'espace réactif.

Selon une autre variante de l'invention (non représentée sur les figures), le sens d'écoulement du mélange gazeux réactif est inversé : le mélange gazeux réactif (8) est introduit dans la zone de dépôt (11) et la quitte en circulant à travers le tube central (14) et/ou les orifices (35) reliés dans ce cas au dispositif de pompage (13).

Selon l'invention, la paroi de la chambre de dépôt (1) en contact avec le plasma est de préférence une pièce monobloc, le plus souvent mais pas exclusivement de symétrie axiale, en quartz, en silice, en tout matériau diélectrique. Cette paroi comprend typiquement une paroi cylindrique englobant la zone (10) dite de formation du plasma raccordée à une paroi (15) tronconique englobant la zone (11) dite de dépôt de diamant.

Selon l'invention, la chambre de dépôt (1), et en particulier la paroi (15) englobant la zone (11) dite de dépôt de diamant, peut avoir d'autres caractéristiques géométriques que celles mentionnées précédemment, caractéristiques adaptées aux dimensions des substrats (5) à traiter.

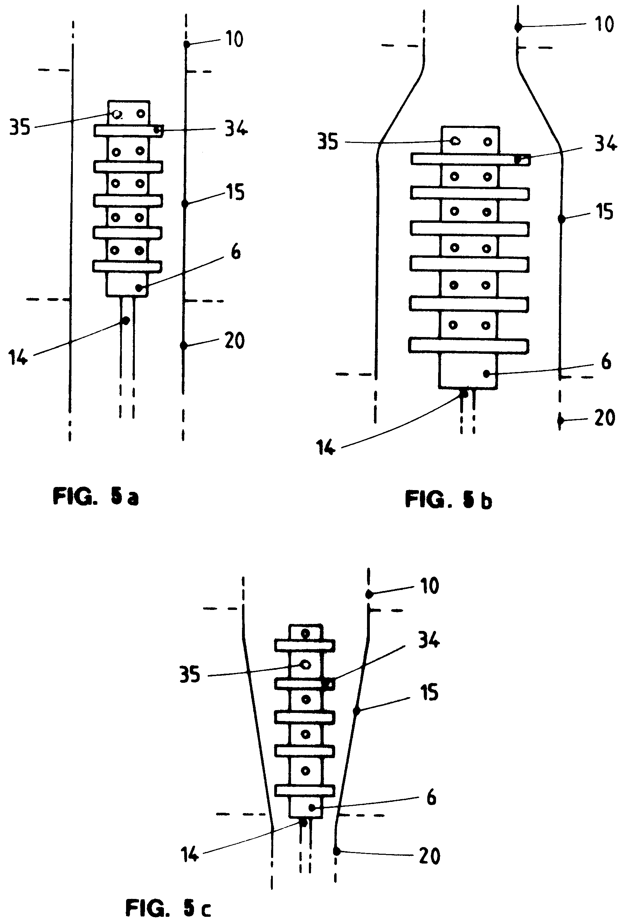

Ainsi, le traitement de joints mécaniques (34), typiquement toriques, peut être réalisé avantageusement dans une zone (11) de dépôt limitée par une paroi cylindrique de diamètre égal (figure 5a) ou supérieur (figure 5b) à celui de la paroi cylindrique correspondant à la zone (10) de formation du plasma. Dans le premier cas, des joints de diamètre voisin de 55 mm peuvent être traités, alors que dans le second cas, des joints de diamètre dépassant 55 mm peuvent être traités selon l'invention.
Par ailleurs, dans le cas d'un support (6) cylindrique, il peut être avantageux de limiter tout ou partie de la zone de dépôt (11) par une paroi tronconique, telle que représenté à la figure 5c, orientée de manière à compenser la décroissance de la densité électronique, au fur et à mesure qu'augmente la distance entre le substrat (5) à traiter et la zone (10) de formation du plasma, par une diminution de l'espace réactif et ainsi à obtenir un dépôt homogène de diamant sur l'ensemble des substrats.

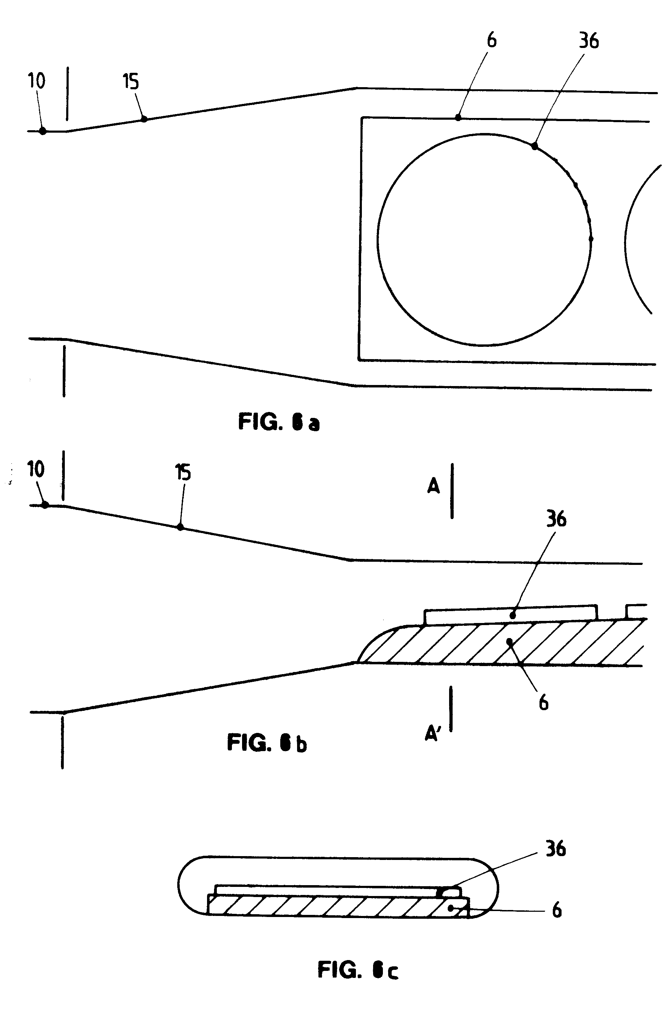

Selon une autre modalité de l'invention, la paroi (15) englobant la zone (11) dite de dépôt de diamant peut avoir une forme aplatie, comme représenté aux figures 6a à 6c, de manière à pouvoir traiter des substrats plan de grand diamètre (36), typiquement voisins de 10 cm, substrats destinés par exemple à l'industrie électronique.

Quelle que soit la forme de la zone (11) de dépôt du diamant, il est possible d'adapter la paroi (15) et/ou le support (6) de manière à avoir une diminution progressive de la distance entre la paroi (15) et le support (6) (comme illustré à la figure 4) de manière à compenser les phénomènes d'appauvrissement en mélange gazeux réactif (8).

### EXEMPLE DE DISPOSITIF

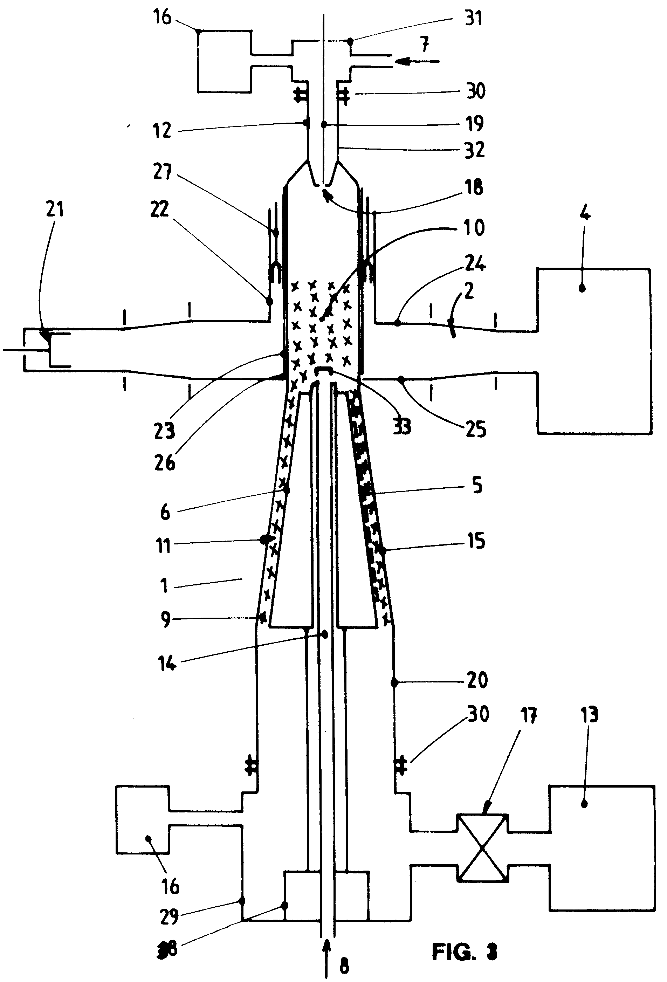

Le dispositif selon l'invention sera mieux compris à l'aide d'un exemple de réalisation non limitatif schématisé à la figure 3.

Dans cet exemple, le SGO utilisé est équipé d'un magnétron qui émet une onde électromagnétique à une fréquence de 2,45 GHz et avec une puissance de 6 kW.
Son tube métallique intérieur (23) a un diamètre intérieur de 80 mm.
Son tube extérieur (22) est refroidi à l'eau.
Les pistons (21) et (27) permettent d'optimiser le couplage avec le plasma en corrélation avec une minimisation de la puissance réfléchie au niveau du magnétron, de manière à ne pas l'endommager et à utiliser l'essentiel de la puissance délivrée à la formation et l'entretien du plasma.

La chambre de dépôt (1) utilisée comprend :
- une paroi cylindrique supérieure en quartz correspondant à la zone de formation (10) du plasma, se refermant à son extrémité sur la paroi d'un injecteur (12) de gaz plasmagène (7). Cette paroi cylindrique a un diamètre extérieur légèrement inférieur à 80 mm de manière à pouvoir être glissée sans difficulté dans le tube intérieur (23) du SGO.
- un injecteur (12) comprenant un tube effilé en quartz (32) de 35 mm de diamètre, soudé à la paroi cylindrique de 80 mm de diamètre, dont l'orifice (18) a un diamètre de 0,7 mm, et une enceinte en inox (31) raccordée de manière étanche au tube effilé (32) grâce à un joint torique (30). Cette enceinte inox (31) comporte une arrivée de gaz plasmagène (7), une jauge de pression (16) et un moyen de positionnement du pointeau (19) et d'asservissement de sa hauteur de manière à assurer une vitesse d'éjection du gaz plasmagène suffisante pour écarter le plasma de l'orifice (18), quel que soit le débit de gaz plasmagène (7).
- une paroi tronconique (15) en quartz correspondant à la partie active de la zone de dépôt (11), de 300 mm de hauteur, prolongée par une paroi cylindrique (20) également en quartz de 160 mm de diamètre.
   Toutes les parois en quartz de la chambre de dépôt sont de préférence constituées d'une seule pièce monobloc en quartz.
- un fond (29) en acier inoxydable raccordé de manière étanche à la paroi cylindrique (20) grâce à des joints toriques (30). Ce fond est équipé d'une jauge (16), de moyens de pompage (13) et d'asservissement de la pression (17). Il est équipé en outre d'un moyen (38) permettant le positionnement du support (6), l'arrivée des gaz réactifs (8) par la conduite (14) munie éventuellement d'un déflecteur (33) à son extrémité et la rotation du support (6) pendant la phase de dépôt afin d'obtenir un dépôt homogène.
   Le support tronconique (6) est en silice. Il a un petit diamètre de 44 mm et un grand diamètre de 125 mm. Sa hauteur est de 280 mm.
   Sur ce support, le substrat se présente sous la forme de 150 disques minces pour outils de coupe en carbure cémenté, chacun d'environ 1 cm² de surface.
- des moyens de chauffage, non représentés sur la figure 3, permettant de chauffer le support et de porter le substrat (5) à une température pouvant atteindre 1000°C.

On a représenté par des croix (x) sur la figure 3 l'espace occupé par le plasma (9) à l'intérieur de la chambre de dépôt : on peut observer que le plasma est maintenu dans la cavité 10 et dans l'espace réactif limité extérieurement par la paroi tronconique (15).
Ce confinement du plasma résulte aussi du fait que le gaz plasmagène est toujours injecté, dans la chambre de dépôt, à grande vitesse à travers l'orifice (18), ce qui empêche le plasma de remonter dans l'injecteur (12).

Le deuxième objet de l'invention est un procédé de dépôt de diamant par DCPV assisté par microonde et utilisant le dispositif de l'invention.

Dans ce procédé, les paramètres mêmes de la mise en oeuvre sont considérés comme étant ceux déjà connus, qu'il s'agisse de la nature des gaz plasmagènes, des compositions gazeuses favorisant la nucléation et la croissance des cristaux de diamant plutôt que la formation de graphite, du choix des gaz porteur de carbone, des températures de traitement, généralement comprises entre 800 et 1100°C et souvent voisines de 1000°C.

En ce qui concerne le substrat (5), le procédé selon l'invention permet de traiter soit un grand nombre de substrats de toute nature déposés sur un support, soit, compte tenu de l'augmentation de volume de la chambre de dépôt, de traiter des pièces entières, pouvant avoir une forme tronconique, par exemple des radomes et des irdomes pour l'industrie aéronautique ou spatiale.

### EXEMPLE DE MISE EN OEUVRE DU PROCEDE

Après avoir réalisé un vide primaire dans la chambre de dépôt (1), y compris dans l'injecteur (12), on a introduit dans l'injecteur (12) de l'argon, comme gaz plasmagène (7), à un débit de 2,8 l/min, de manière à effectuer un balayage d'argon sous une pression de 666 Pa (5 torr).
Après ce balayage, on a mis le générateur microondes (4) en route et un plasma est crée au sein de la chambre de dépôt. On porte le générateur (4) à la puissance maximum de 6 kW tout en optimisant le couplage avec le plasma, à l'aide des pistons (21) et (27). Même avec une puissance de 6 kW, la puissance réfléchie est quasi nulle.

On a introduit alors de l'hydrogène par la conduite (14) à un débit de 0,6 l/min et on a porté ensuite la température des substrats (5) à température intermédiaire d'environ 750 °C puis à 930 °C environ.

Ensuite, on a introduit également par la conduite (14) du méthane à un débit de 18 cm³/min et, de manière à favoriser la vitesse de nucléation et de croîssance du diamant relativement à celle du graphite on a introduit de l'oxygène à un débit de 6 cm³/min dans l'argon.

On a poursuivi le dépôt de diamant pendant 10 h en conservant les mêmes paramètres :
* température du substrat : 930 °C
* débits de gaz plasmagène
   argon : 2,8 l/min
   oxygène : 6 cm³/min
* débits des gaz réactifs
   hydrogène : 0,6 l/min
   méthane : 18 cm³/min

A la fin, on arrête le débit d'oxygène, de méthane, d'hydrogène, puis le générateur de microondes et enfin le débit d'argon ainsi que les moyens de chauffage.
Après avoir remis à l'air la chambre de dépôt, on a sorti le substrat en désolidarisant le fond (29) de la paroi cylindrique (20).
On a obtenu un dépôt de diamant de 10 µm sur les 150 plaquettes pour outils de coupe constituant le substrat.

D'autres essais ont été réalisés en modifiant les compositions gazeuses du gaz plasmagène (7) et du mélange gazeux réactif (8), avec cependant dans tous les cas un gaz plasmagène (7) contenant de l'argon et un mélange gazeux réactif (8) contenant de l'hydrogène.
En particulier, il est possible d'une part d'introduire l'élément oxygène dans le gaz plasmagène (7) et/ou dans le mélange réactif (8), et d'autre part de l'introduire soit sous forme d'oxygène moléculaire O₂, soit sous forme combinée (CO, CO₂, H₂O, etc...). Il faut noter que CO ou CO₂ sont utilisables selon l'invention comme molécules simultanément porteuses des éléments oxygène et carbone.

### AVANTAGES DE L'INVENTION

L'invention permet d'étendre considérablement les possibilités de dépôt de diamant par la voie DCPV assistée par microondes. En effet, la surface de dépôt accessible selon l'art antérieur était typiquement d'environ 80 cm², alors que l'invention permet d'accéder à des surfaces de l'ordre de plusieurs centaines de cm² soit une capacité de traitement (typiquement de 200 à 400 cm²) notablement multipliée par rapport à l'art antérieur.

Mais ce qui est encore plus important, c'est qu'il s'agit là d'une première étape d'une voie nouvelle basée sur l'idée de "faire sortir" le plasma du volume limité de l'art antérieur, voie qui ouvre de nombreuses possibilités, telles par exemple que le dépôt de diamant sur des pièces de grande surface. Car, dorénavant, il sera possible d'augmenter la puissance des générateurs microonde, et donc la surface de dépôt, puisque cette puissance générée trouve une possibilité de s'étendre dans un grand volume et de se dissiper dans un plasma de grand volume/ grande surface, alors qu'une augmentation de puissance "à volume constant" de l'art antérieur conduit immédiatement à la destruction des équipements.

Selon l'invention, il est possible de modifier et d'adapter le profil de la paroi (15) de la zone de dépôt au profil du substrat, en particulier quand ce substrat est une pièce monobloc qui peut avoir un profil spécifique, par exemple en forme d'ogive, s'écartant donc légèrement d'une forme strictement tronconique, de manière à avoir une distance entre paroi (15) et substrat (6) permettant un dépôt de diamant régulier.

### APPLICATIONS

Dans certaines applications, les dépôts de diamant en surface constituent une couche de grande dureté et donc une couche de protection efficace permettant d'augmenter la durabilité des pièces traitées :
- radome et irdome (pièce analogue au radome mais pour le rayonnement infra-rouge), hublots pour lumière infra-rouge, capteurs divers faisant partie de l'"électronique embarquée" dans l'industrie aéronautique, spatiale au sens le plus large (stations, fusées, missiles, etc...).
- inserts de carbure de tungstène fritté pour coupe
- joints mécaniques pour étanchéité dynamique

Utilisation de la conductivité thermique dans les drains thermiques pour électronique et optoélectronique.

### DESCRIPTION DES FIGURES

La figure 1 est une vue en perspective d'un surfatron guide d'ondes (SGO) qui montre la disposition relative du guide d'ondes (2), de la ligne coaxiale (tube 22 et piston 27), et du tube (28) contenant le plasma (9).

La figure 2 est une vue en coupe d'un SGO avec mention des principaux éléments.

La figure 3 est une vue en coupe d'un dispositif typique selon l'invention.

La figure 4 est une vue schématique (coupe transversale longitudinale) d'une chambre de dépot (1) avec ses différentes zones et avec les divers flux gazeux qui la parcourent. On a représenté sur cette figure un support (6) en forme de cône tronqué dont l'angle au sommet est plus grand que celui de la paroi tronconique (15), de façon à conserver une vitesse de dépôt uniforme sur l'ensemble de l'espace réactif.

Les figures 5a à 5c représentent schématiquement en coupe transversale longitudinale différents types de parois limitant la zone (11) de dépôt, dans le cas de supports (6) cylindriques :
- paroi cylindrique de diamètre égal (figure 5a) ou supérieur (figure 5b) à celui de la paroi cylindrique correspondant à la zone (10) de formation du plasma.
- paroi tronconique (figure 5c) de façon à compenser les phénomènes d'appauvrissement en gaz réactif (8).

Des joints (34) disposés sur un support (6) sont schématisés sur ces figures. Le support (6) est muni d'orifices (35) permettant un écoulement des gaz réactifs entre chaque joint (34).

Les figures 6a à 6c illustrent le cas où la zone (11) dite de dépôt de diamant a une forme aplatie.
La figure 6a est une vue longitudinale de face.
La figure 6b est une vue longitudinale (coupe) de profil.
La figure 6c est une vue transversale (coupe) selon le plan AA′ de la figure 6b.
Les substrats plan sont des disques (36) placés sur le support (6).

## Revendications

**1 -** Dispositif de dépôt de diamant sur substrat, assisté par plasma microonde, qui comporte une chambre de dépôt (1), dont une portion est placée dans un guide d'ondes (2) alimenté par un générateur de microondes (4) et équipé d'un dispositif annihilant la puissance réfléchie vers ce générateur, chambre qui contient un substrat (5) à traiter placé sur un support (6), des moyens de chauffage du substrat, des moyens pour faire circuler dans ladite chambre, et sous une pression faible et régulée, un gaz plasmagène (7) et un mélange gazeux réactif (8) constitué d'hydrogène et de gaz porteur de carbone, et caractérisé en ce que, de manière à obtenir un plasma stable (9) dans un grand volume et/ou sur une grande surface,
a) la chambre de dépôt (1) comprend deux zones raccordées,l'une, de petit volume, étant la zone (10) dite de formation du plasma située à l'intérieur du volume délimité par le guide d'ondes (2), et l'autre, de grand volume/ de grande surface, étant la zone (11) dite de dépôt du diamant située hors du volume délimité par le guide d'ondes (2), et contenant ledit substrat (5),
b) ledit guide d'ondes (2) est muni de moyens permettant de former un plasma stable dans la zone de dépôt (11), située hors du volume délimité par le guide d'ondes (2) et contenant le substrat (5) à traiter.

**2 -** Dispositif selon la revendication 1 dans lequel lesdits moyens permettant de former un plasma stable dans la zone de dépôt (11) sont choisis parmi le surfaguide, le surfatron et le surfatron à guide d'onde.

**3 -** Dispositif selon la revendication 3 dans lequel ledit moyen permettant de former un plasma stable dans la zone de dépôt (11) est de préférence le surfatron à guide d'onde.

**4 -** Dispositif selon la revendication 3 dans lequel ledit générateur de microondes (4) a une puissance élevée d'au moins 5 kW.

**5 -** Dispositif selon une quelconque des revendications 1 à 4 dans lequel ledit générateur de microondes (4) fonctionne à une fréquence choisie dans le domaine 0,05 - 10 GHz.

**6 -** Dispositif selon une quelconque des revendications 1 à 5 dans lequel ladite zone de dépôt (11), de grand volume relatif, comprend une partie active pour le dépôt de diamant, à paroi tronconique (15) raccordée, au niveau de son petit diamètre, à ladite zone (10) de formation du plasma de petit volume relatif.

**7 -** Dispositif selon la revendication 6 dans lequel le grand diamètre de la paroi (15) tronconique est au moins 1,5 fois plus grand que son petit diamètre.

**8 -** Dispositif selon une quelconque des revendications 6 à 7 dans lequel ladite partie active pour le dépôt du diamant, à paroi (15) tronconique, peut contenir un support (6) ou un substrat monobloc de forme sensiblement tronconique de manière à avoir, dans l'espace réactif entre paroi (15) tronconique et substrat (5), un plasma sensiblement homogène de manière à obtenir une épaisseur de diamant régulière sur les substrats (5) placés sur lesdits supports (6).

**9 -** Dispositif selon une quelconque des revendications 1 à 5 dans lequel ladite zone de dépôt (11), de grand volume relatif, comprend une partie active pour le dépôt de diamant, à paroi (15) cylindrique raccordée à ladite zone (10) de formation du plasma de petit volume relatif.

**10 -** Dispositif selon une quelconque des revendications 1 à 5 dans lequel ladite zone de dépôt (11), de grand volume relatif, comprend une partie active pour le dépôt de diamant, à paroi (15) aplatie raccordée à ladite zone (10) de formation du plasma de petit volume relatif.

**11 -** Dispositif selon une quelconque des revendications 1 à 10 dans lequel on adapte la paroi (15) et le support (6) de manière à avoir une diminution progressive de la distance entre la paroi (15) et le support (6) et à compenser les phénomènes d'appauvrissement en mélange gazeux réactif (8).

**12 -** Dispositif selon une quelconque des revendications 1 à 11 dans lequel la surface de support (6) en contact avec le plasma est supérieure à 300 cm².

**13 -** Dispositif selon une quelconque des revendications 1 à 12 dans lequel le flux de gaz plasmagène (7) traverse l'ensemble de la chambre de dépôt (1) grâce à un injecteur (12) de gaz plasmagène situé à une extrémité de ladite chambre en amont de la zone de formation du plasma, et grâce à des moyens de pompage de l'atmosphère gazeuse de ladite chambre situés à l'autre extrémité.

**14 -** Dispositif selon la revendication 13 dans lequel l'injecteur (12) est muni de moyens assurant une grande vitesse d'entrée du flux plasmagène dans ladite chambre (1), de manière à écarter le plasma de l'injecteur.

**15 -** Dispositif selon une quelconque des revendications 1 à 14 dans lequel ledit mélange gazeux réactif (8) est introduit dans la chambre de dépôt (1) à l'aide d'une alimentation centrale (14) traversant ladite zone de dépôt de diamant (11) et débouchant à la limite des dites zones (10) de formation du plasma et (11) de dépôt.

**16 -** Dispositif selon la revendication 15 dans lequel ladite alimentation centrale (14) est munie à son extrémité d'un déflecteur (33) permettant d'obtenir un flux radial du mélange gazeux réactif(8), de manière à avoir une atmosphère gazeuse sensiblement homogène dans la zone de dépôt.

**17 -** Dispositif selon une quelconque des revendications 1 à 14 dans lequel ledit mélange gazeux réactif (8) est introduit dans la chambre de dépôt (1) à l'aide d'une alimentation centrale (14), traversant ladite zone de dépôt de diamant (11), munie de plusieurs orifices débouchant en différents points de l'espace réactif.

**18 -** Dispositif selon une quelconque des revendications 1 à 17 dans lequel le fond (29) de la chambre de dépôt (1) est muni de moyens permettant la rotation du support (6), de manière à obtenir un dépôt homogène.

**19 -** Dispositif selon une quelconque des revendications 1 à 14 dans lequel ledit mélange gazeux réactif (8) est introduit dans la zone de dépôt (11) et la quitte en circulant à travers ladite alimentation centrale (14) et/ou les orifices (35) reliés dans ce cas au dispositif de pompage (13).

**20 -** Procédé de dépôt de diamant sur un substrat à l'aide du dispositif défini selon une quelconque des revendications 1 à 19 dans lequel le dépôt a lieu à une température comprise entre 600 et 1100°C, avec un gaz plasmagène comprenant de l'argon, et avec un flux de gaz réactifs comprenant de l'hydrogène et un gaz porteur de carbone.

**21 -** Procédé selon la revendication 20 dans lequel ledit flux de gaz réactifs et/ou ledit gaz plasmagène comprend de l'oxygène sous forme moléculaire ou combiné à d'autres éléments, de préférence choisis parmi le carbone et l'hydrogène.

**22 -** Procédé selon la revendication 21 dans lequel le substrat (5) est constitué par un grand nombre de pièces placées sur un support (6).

**23 -** Procédé selon la revendication 21 dans lequel le substrat (5) est constitué par une pièce monobloc.
